Europäisches Patentamt

European Patent Office

Office européen des brevets

(11) Publication number: **0 126 337**
**A2**

## EUROPEAN PATENT APPLICATION

(21) Application number: **84104767.3**

(22) Date of filing: **27.04.84**

(51) Int. Cl.³: **H 03 G 3/20**, H 03 G 1/00

(30) Priority: **03.05.83 US 491167**

(43) Date of publication of application: **28.11.84**
**Bulletin 84/48**

(84) Designated Contracting States: **AT BE CH DE FR GB IT LI LU NL SE**

(71) Applicant: **RACAL DATA COMMUNICATIONS, INC., 1525 McCarthy Boulevard, Milpitas California 95035 (US)**

(72) Inventor: **Bingham, John A. C., 2353 Webster Street, Palo Alto California 94301 (US)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(54) **Switched-capacitor AGC system.**

(57) An automatic gain control (AGC) system provides a serial digital output. An analog-to-digital converter implemented by SC technology receives an analog input voltage signal ($V_{in}$) and converts it to a digital word through an iterative algorithmic process involving successive approximation against an input reference voltage ($V_R$) from a reference voltage generator. The reference voltage generator comprises an SC full-wave rectifier receiving the analog input voltage and an active low-pass filter.

- Λ -

# SWITCHED-CAPACITOR AGC SYSTEM

The present invention relates to digital automatic gain control (AGC) systems.

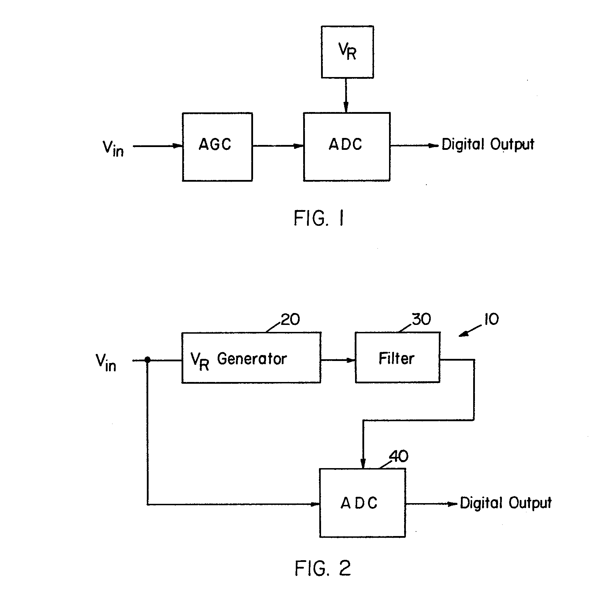

Heretofore, digital AGC systems have been realized in the manner shown in Figure 1. That is, an input voltage $V_{in}$ is applied to an analog AGC circuit. The output of the AGC circuit is then applied as the analog input to an algorithmic ADC requiring a reference voltage $V_R$. Since the quality of the conversion is dependent upon the stability of $V_R$, a regulated reference voltage source is required. Further, implementation of the system in switched-capacitor technology is difficult because the analog AGC does not readily admit to such construction.

The present invention provides an improved digital AGC system that is readily implemented in SC technology. Further, the invention provides an AGC system in which the quality of conversion is independent of the reference voltage. Finally, the invention provides a digital AGC system affording a wide dynamic range by providing for control of the reference voltage used by the ADC.

The digital AGC system of the present invention includes a reference voltage generator responsive to the system input voltage. The reference voltage provided tracks the absolute level of the input signal and provides a DC level corresponding to the average thereof. The system further includes an algorithmic analog-to-digital converter receiving the input voltage and the reference voltage.

The AGC system is preferably implemented in SC technology. The reference voltage source is preferably an SC full-wave rectifier. The ADC is preferably a recycling ADC.

A written description setting forth the best mode presently known for carrying out the present invention, and of the manner of implementing and using it, is provided by the following detailed description of preferred embodiments which are illustrated in the attached drawings wherein:

Figure 1 is a block diagram of prior art digital AGC apparatus;

Figure 2 is a block diagram of digital AGC apparatus in accordance with the present invention;

Figure 3 is a more detailed schematic diagram of the apparatus diagrammed in Figure 2;

Figure 4 is a schematic diagram of a switched-capacitor circuit ADC for use in the apparatus diagrammed in Figure 3;

Figure 5 is a timing diagram illustrating switch actuations in the circuit of Figure 4, for providing an ADC function; and

Figure 6 is a schematic diagram of the control logic portion of the ADC shown in Figure 4, for providing the switch actuation signals.

Referring now to Figure 2, there is shown a block diagram of digital AGC apparatus in accordance with the present invention. The system 10 includes a reference voltage generator 20 which receives the system input voltage signals $V_{in}$. The reference voltage generator 20 in response to the input voltage signal produces a DC voltage level representative of the amplitude of the input voltage signal. The output of the reference voltage generator is applied to a filter circuit 30, which produces the final reference voltage signal. The system 10 further includes an analog-to-digital converter 40. Both the system input voltage and the reference voltage are applied to ADC 40. The input voltage is converted to a digital output by ADC 40 using an iterative algorithmic conversion process.

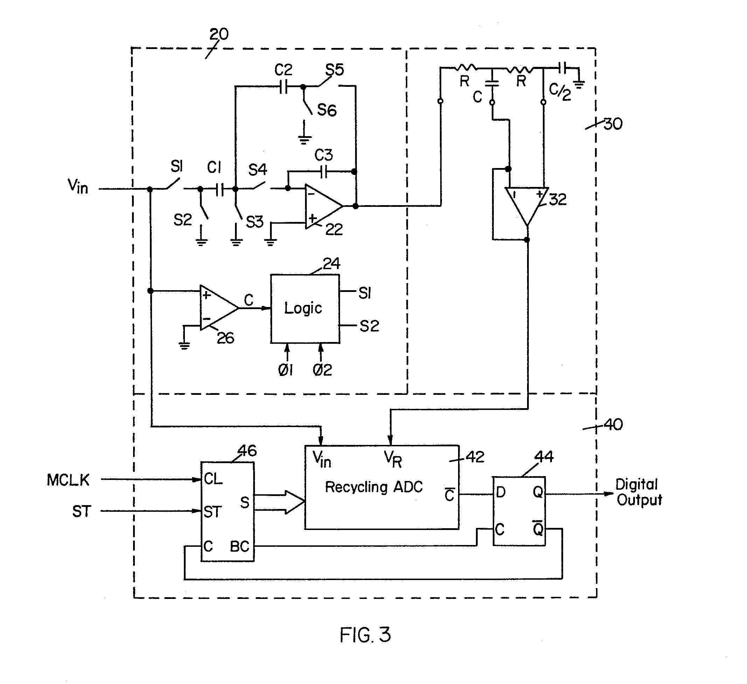

Turning now to Figure 3, there is shown in greater detail the digital AGC system of Figure 2. As shown, the reference voltage generator block 20 is implemented by a switched-capacitor rectifier circuit. The particular circuit shown is a full-wave rectifier. This circuit is built around op-amp 22 and includes switches S1, S2, S3, and S4 and capacitors C1, C2, and C3. Actuation of input switches S1 and S2 is in response to control signals provided by logic circuit 24. A comparator circuit 26 generates a binary signal C with the value of logical one or zero if the voltage signal is positive or negative respectively. The switches in block 20 are actuated in accordance with switch control signals derived from two non-overlapping clocks $\emptyset 1$ and $\emptyset 2$. The switch actuation signals are defined in Table I below.

TABLE  I

$$S1 = C\ \emptyset 2 + \overline{C}\ \emptyset 1$$
$$S2 = C\ \emptyset 1 + \overline{C}\ \emptyset 2 \qquad \bullet$$
$$S3 = \emptyset 2$$
$$S4 = \emptyset 1$$
$$S5 = \emptyset 1$$
$$S6 = \emptyset 2$$

Further details regarding SC circuits and in particular the principles on which the SC rectifier in Figure 3 is based may be obtained from Bingham, U.S. Patent No. 4,295,105, issued October 13, 1981, and entitled "Switched-Capacitor Modulator". The disclosure in this patent is hereby incorporated by reference.

The rectified output is applied to low pass filter block 30. This filter is suitably a second order Butterworth filter. As shown in Figure 3, the filter is implemented by an op-amp 32 and an input RC network including two resistors and two capacitors. The resistors are of equal value R. The capacitors, as indicated, have values of C and C/2. The output of op-amp 32 is the reference voltage to be applied to ADC 40.

In Figure 3, ADC block 40 is further diagrammed to show therein a recycling ADC circuit 42, flip-flop 44, and control logic 46. The control logic receives the master clock MCLK input and the start pulse signal ST. From these signals and a series of four non-overlapping clock signals, the appropriate control signals for recycling ADC 42 are produced.

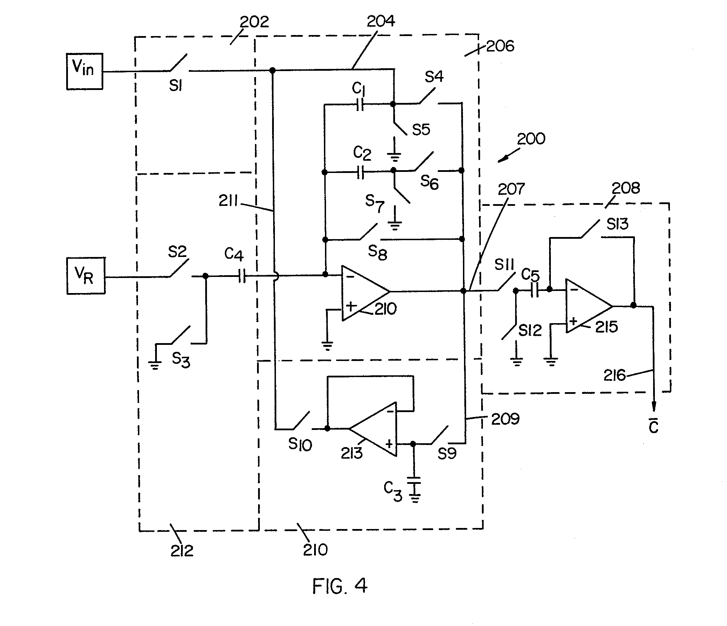

Referring now to Figure 4, there is diagrammed circuitry for implementing recycling ADC 42 which operates in accordance with an iterative algorithm as described in McCharles et al. "An Algorithmic Analog-to-Digital Converter," IEEE Int'l Solid-State Circuits Conf. Digest of Tech. Papers (1977), pp. 96-97. In Figure 4, the input voltage signal $V_{in}$ is by means 202 to provide an input voltage sample. The input voltage source may be either a sample-and-hold circuit or it may be a conductor carrying thereon a continuous analog signal. Switch S1 couples the input voltage source signal onto conductor 204, which serves as the input to a recycling integrator 206. The recycling integrator includes op-amp 210; capacitors C1 and C2; and switches S4, S5, S6, S7, and S8. The output of recycling integrator 206 is applied to comparator 208 and delay circuit 210 over conductors 207 and 209, respectively.

Recycling ADC 42 accesses the reference voltage level $V_R$ through a switch S2 which selectively couples the reference voltage to capacitor C4. Additionally, switch S3 is provided for selectively connecting capacitor C4 to ground potential.

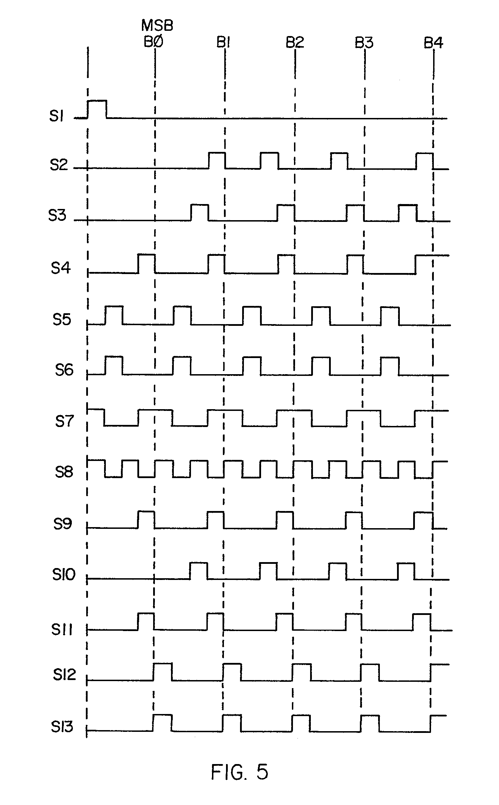

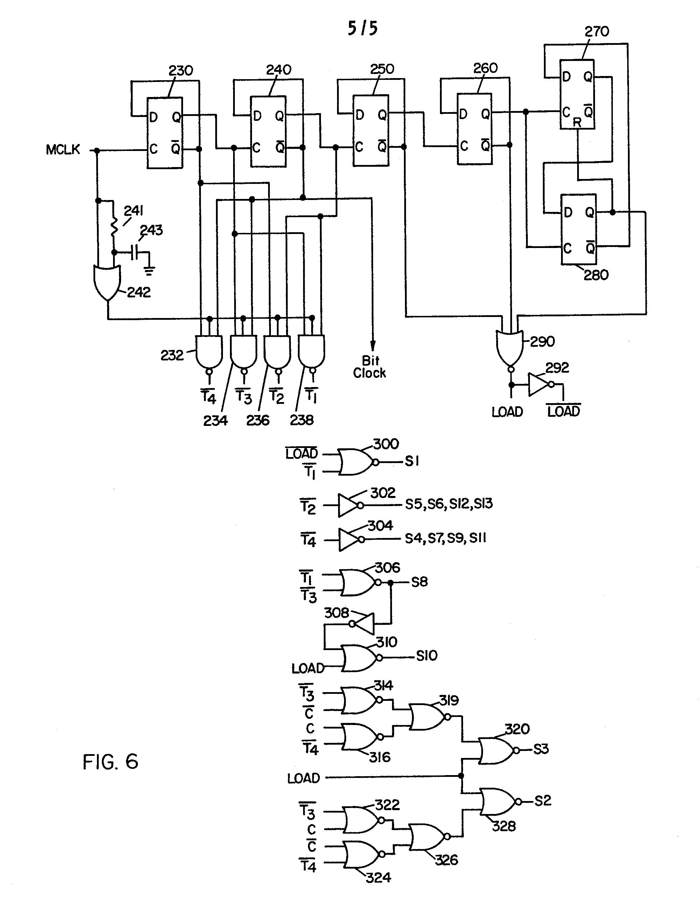

Referring to Figure 5, there is presented a timing diagram which illustrates the switch actuations required in operating the circuitry of Figure 4 to realize analog-to-digital conversion. With reference to Figure 6, there is diagrammed digital logic circuitry for generating the switch actuation signals provided by control logic 46 in Figure 3.

Considering now Figures 4 and 5, in operation of recycling ADC 42, switch S1 is closed to provide the input voltage sample to recycling integrator 206. As indicated in the timing diagram of Figure 5, when switch S1 is closed, switches S7 and S8 are also closed. This causes capacitor C1 to be charged to a voltage level equal to the input voltage minus the offset voltage of op-amp 210. Capacitor C2 is charged to the offset voltage level. Next, switches S5 and S6 are closed and all others opened. This results in the voltage on capacitor C1 being transferred to capacitor C2. In the next step in the operation, only S8 is closed in order to refresh the offset voltage at the input of op-amp 210. Switches S4 and S7 are then closed to transfer the voltage on capacitor C2 back onto capacitor C1. The output voltage available from op-amp 210 over line 207 to comparator 208 and over line 209 to delay circuit 210 is the input voltage amplified by a perfect unity gain. Further, the voltage is independent of capacitor ratios and op-amp offset voltage.

The voltage available at the output of op-amp 210 is then stored in delay circuit 210. Delay circuit 210 shown in Figure 4 is a sample-and-hold circuit comprising switch S9, storage capacitor C3 and buffer amplifier 213. Voltage is stored in the sample-and-hold circuit by closure of switch S9, placing the op-amp output voltage on C3. The voltage stored in the sample-and-hold delay circuit is. selectively made available therefrom by switch S10 and over conductor 211 to conductor 204 of the recycling integrator circuit.

The output voltage of op-amp 100 is further applied to comparator 208 by closure of switch S11, which places the voltage on capacitor C5. As indicated in the timing diagram of Figure 5, after switch S11 in comparator 208 opens, switches S12 and S13 are closed. This configures op-amp 215 as a comparator. The voltage stored on capacitor C5 is compared to ground potential to determine whether the voltage is positive or negative. The result of the comparison, which is indicated as either a logic 1 or a logic 0, is made available over conductor 216 to flip-flop 44 in Figure 3.  With reference to Figure 3, an appropriately timed bit clock pulse BC is applied to the clock input of flip-flop 44 to store the bit value of the comparison.  Available from the Q and $\overline{Q}$ outputs of flip-flop 44 are the signals C and $\overline{C}$ which are utilized as the ADC output and an input to the logic circuitry diagrammed in Figure 6.

At the same time comparator 208 is in operation, switches S7 and S8 in the recycling integrator are again closed.  Closure of these two switches results in the voltage on capacitor C1 being reduced by the operational amplifier offset voltage, and capacitor C2 being charged to the offset voltage level.  Subsequent closure of switches S5 and S6 as indicated in the timing diagram causes the voltage on capacitor C1 to be transferred to capacitor C2.  Switch S8 is closed to refresh the offset voltage.  Simultaneously, switch S10 in delay circuit 210 is closed.  This results in capacitor C1 integrating charge up to the voltage level stored on capacitor C3. Next, switches S4 and S7 are closed to transfer to C1 the voltage on capacitor C2, which is equal to the voltage stored on capacitor C3.  This, of course, results in a voltage on C1 that is double the previous voltage.  Since the previous voltage was equal to $V_{in}$, the new voltage on capacitor C1 is $2V_{in}$.  Accordingly, a "times two" function is achieved.

As further required by the successive-approximation algorithm implemented by ADC 40, based upon the resolution by comparator 208 of the previous voltage into a binary digit value, the reference voltage must be either added to or subtracted from the "new" voltage on capacitor C1. Assuming the previous voltage output from the recycling integrator was positive, the output of comparator 208 would be a logic 1.  Thus, the reference voltage $V_R$ should be subtracted from the "times two" voltage on capacitor C1.

The adding or subtracting of $V_R$ is controlled by the sequence of switch closures for switches S2 and S3.  To subtract $V_R$ from the voltage on C1, switch S3 is first closed.  Simultaneously, switch S8 is closed.  This clears capacitors C4.  Thereafter, S3 is opened and switch S2 is closed.  This results in a negative reference voltage being integrated onto capacitor C1, which effectively subtracts $V_R$ from $2V_{in}$.

To add the reference voltage to the "times two" voltage on capacitor C1, the sequence of switch closures for switches S2 and S3 is reversed.  That is, switch S2 is first closed to charge capacitor C4 to the reference voltage level.  Subsequently, switch S3 is closed.  This results in the positive reference voltage on capacitor C4 being transferred to capacitor C1  Effectively, the reference voltage is added to the "times two" voltage on capacitor C1.

The voltage on capacitor C1 is then applied to comparator 208 and delay circuit 209, and for purposes of the next bit determination, it becomes the previous voltage which undergoes the "times two" processing in recycling integrator 206.

The above discussion carries operation of the ADC converter apparatus 42 through the resolution of only two bits, the most significant bit (MSB) and the next lower ordered bit.  The analog processing and comparison operations continue repeatedly until the last bit to be resolved is obtained.  Thereafter, switch S1 is actuated to bring in a new input voltage sample for conversion.

With reference to Figure 6, digital logic for generating the required switch actuation signals for use in Figure 4 is diagrammed. As indicated, a master clock signal designated MCLK is applied to a group of flip-flops designated by the reference numerals 230, 240, 250, 260, 270, and 280. The outputs of flip-flops 230 and 240 are applied to NAND gates 232, 234, 236, and 238. An additional input to these gates is the output of OR gate 242 which is configured as a timed one-shot device utilizing the RC timing network of resistor 241 and capacitor 243. The outputs of the NAND gates provide the non-overlapping clock signals of $\overline{T_1}$, $\overline{T_2}$, $\overline{T_3}$, and $\overline{T_4}$. Additionally the $\overline{Q}$ output of flip-flop 240 provides the bit clock signal which is applied to flip-flop 44 in Figure 3. The outputs of flip-flops 250, 260, and 280 are applied as inputs to NOR gate 290 to generate the Load signal. Inverter 292 inverts the output of NOR gate 290 to provide the $\overline{\text{Load}}$ signal.

The various $\overline{T}$ clock signals, the Load and $\overline{\text{Load}}$ signals are applied as input signals to logic comprising a number of gates to produce the switch actuation signals. NOR gate 300 produces the switch S1 actuation signal. Inverter 302 provides the actuation signal for switches S5, S6, S12, and S13. Inverter 304 provides the switch actuation signal to S4, S7, S9, and S11. NOR gate 306 provides the switch S8 actuation signal. Furthermore, the output of NOR gate 306 after inversion by inverter is applied as an input to NOR gate 310 to produce the switch S10 actuation signal. Logic comprising NOR gates 314, 316, 318, 320, 322, 324, 326, and 328 provide the actuation signals for switches S2 and S3. To be noted also is that the signal C from flip-flop 44 in Figure 3 and $\overline{C}$ derived therefrom are applied as inputs to NOR gates 314, 316, 322, and 324.

0126337

The foregoing description of the invention has been directed to a particular preferred embodiment for purposes of explanation and illustration. It will be apparent, however, to those skilled in this art that many modifications and changes in the structure shown may be made without departing from the essence of the invention. It is the Applicant's intention in the following claims to cover all equivalent modifications and variations as fall within the scope of the appended claims.

CLAIMS:

1.  A digital automatic gain control system, comprising:

an analog-to-digital converter, for converting an analog input signal to a digital word through an iterative algorithmic process involving successive approximation against an input reference voltage; and

a reference voltage generator, for producing the input reference voltage for the analog-to-digital converter,

said reference voltage generator receiving the analog input signal applied to the analog-to-digital converter and generating an input reference voltage level as a function of the analog input voltage level.

2.  The system of claim 1 wherein the reference voltage generator comprises a switched-capacitor (SC) full-wave rectifier circuit.

3.  The system of claim 2 further comprising:

a low-pass filter circuit coupled to the SC rectifier circuit and providing a voltage output applied to the analog-to-digital converter as the input reference voltage.

4.  A method of digital automatic gain control, comprising the steps of:

applying an analog input voltage to be converted to a digital word to a means for generating a DC reference voltage functionally related to the amplitude of the analog input voltage; and

applying the analog input voltage and the reference voltage to an iterative algorithmic analog-to digital converter performing the conversion through successive approximation against the reference voltage.

1/5

FIG. 1

FIG. 2

0126337

2/5

FIG. 3

FIG. 4

0126337

4/5

FIG. 5

FIG. 6

0126337